# EUROPÄISCHE PATENTANMELDUNG

(11) **EP 1 564 594 A1**
(43) Veröffentlichungstag der Anmeldung: **17.08.2005**
(21) Anmeldenummer: 05003231.7
(22) Anmeldetag: 16.02.2005
(51) Int. Cl.: G03F 7/20

(54) **Projektionsobjektiv für die Mikrolithographie**

(30) Priorität: 17.02.2004 US 544492 P
(71) Anmelder: Carl Zeiss SMT AG, 73447 Oberkochen (DE)
(72) Erfinder: Zaczek, Christoph, 73540 Heubach (DE); Shafer, David, Fairfield Connecticut 06430 (US); Ulrich, Wilhelm, 73434 Aalen (DE)
(74) Vertreter: Patentanwälte Ruff, Wilhelm, Beier, Dauster & Partner

(57) **Zusammenfassung**

Ein Projektionsobjektiv (5) für die Mikrolithographie zur Abbildung eines in einer Objektebene (8) des Projektionsobjektivs (5) angeordneten Musters in eine Bildebene (11) des Projektionsobjektivs (5) weist im Lichtweg zwischen der Objektebene (8) und der Bildebene (11) mindestens eine Strahlumlenkeinrichtung (19) mit mindestens einer Totalreflexionsfläche (17) auf, die derart gegenüber einer Einfallsrichtung der auf die Totalreflexionsfläche (17) einfallenden Strahlung geneigt ist, dass im wesentlichen die gesamte von der Objektebene (8) kommende und auf die Totalreflexionsfläche (17) auftreffende Strahlung an der Totalreflexionsfläche (17) totalreflektiert wird. Mit der Strahlumlenkeinrichtung (19) kann eine hohe Reflektivität bei hohen Inzidenzwinkeln bezüglich der Flächennormalen auf die Totalreflexionsfläche (17) erzielt werden. Hierdurch können insbesondere bei katadioptrischen Projektionsobjektiven Bauformen erstellt werden, die ohne Verwendung der Totalreflexion zur Strahlumlenkung nur mit erheblich größerem baulichen Aufwand realisierbar sind.

## Beschreibung

Die Erfindung betrifft ein Projektionsobjektiv für die Mikrolithographie zur Abbildung eines in einer Objektebene des Projektionsobjektivs angeordneten Musters in eine Bildebene des Projektionsobjektivs.

Derartige Projektionsobjektive werden in Projektionsbelichtungsanlagen zur Herstellung von Halbleiterbauelementen und anderen feinstrukturierten Bauteilen verwendet, insbesondere in Waferscannern und Wafersteppern. Sie dienen dazu, Muster von Photomasken oder Strichplatten, die nachfolgend allgemein als Masken oder Retikel bezeichnet werden, auf einen mit einer lichtempfindlichen Schicht beschichteten Gegenstand mit höchster Auflösung in verkleinertem Maßstab zu projizieren.

Dabei wird es zur Erzeugung immer feinerer Strukturen angestrebt, einerseits die bildseitige numerische Apertur (NA) des Projektionsobjektivs zu vergrößern und andererseits immer kürzere Wellenlängen zu verwenden, vorzugsweise Ultraviolettlicht mit Wellenlängen von unter 260 nm.

In diesem Wellenlängenbereich stehen nur noch wenig ausreichend transparente Materialien zur Herstellung der optischen Komponenten zur Verfügung, insbesondere synthetisches Quarzglas und Fluoridkristalle, wie Calciumfluorid. Die Abbékonstanten dieser Materialien liegen relativ nahe beieinander, so dass es schwierig ist, rein refraktive Systeme mit ausreichender Farbfehlerkorrekur bereitzustellen. Solche Systeme benötigen auch viel Linsenmaterial, welches in geeigneter Qualität nur sehr begrenzt verfügbar ist.

In Anbetracht der Schwierigkeiten bei der Farbkorrektur und begrenzter Verfügbarkeit geeigneter Linsenmaterialien werden für höchstauflösende Projektionsobjektive zunehmend katadioptrische Systeme verwendet, bei denen brechende und reflektierende Komponenten, insbesondere also Linsen und Spiegel, kombiniert sind. Wenn eine obskurationsfreie und vignettierungsfreie Abbildung erreicht werden soll, werden bei der Nutzung von abbildenden Spiegelflächen Strahlumlenkeinrichtungen benötigt, die häufig als Strahlteiler bezeichnet werden. Es sind sowohl Systeme mit geometrischer Strahlteilung, z.B. mit einem oder mehreren voll reflektierenden Umlenkspiegeln, als auch Systeme mit physikalischen Strahlteilern, beispielsweise Polarisationsstrahlteilern, bekannt.

Katadioptrische Projektionsobjektive mit geometrischer Strahlteilung sind beispielsweise der EP 1 260 845 (entsprechend US 2003/0021040 A1) oder der US-Patentanmeldung mit Serial No. 10/166,332 der Anmelderin zu entnehmen. Die Systeme sind hervorragend korrigiert. Beispiele für katadioptrische Projektionsobjektive mit physikalischem Strahlteiler sind in der internationalen Patentanmeldung WO 03/027747 A1 der Anmelderin gezeigt.

Ein Projektionssystem zur Erzeugung eines Videobildes ist aus der US 4,969,730 bekannt. Es umfasst ein Strahlteilerelement, welches zur Einkopplung von Beleuchtungslicht in das Projektionssystem in Reflexion und im Projektionsstrahlengang in Transmission betrieben wird. Die Reflexion wird an einer als Totalreflexionsfläche dienenden Seitenfläche eines Prismas durchgeführt, und zwar bevor das Licht auf ein als Objekt dienendes, reflektives Bilderzeugungsfeld auftrifft.

Wird eine reflektierende Fläche einer Strahlumlenkeinrichtung von einem Strahlbündel unter hohen Inzidenzwinkeln bezüglich ihrer Flächennormalen getroffen, kann ein erheblicher Teil der Strahlung an dieser Fläche absorbiert oder gestreut werden, so dass die Strahlungsintensität des Strahlbündels nach der Umlenkung erheblich vermindert und/oder über den Strahlbündelquerschnitt ungleichmäßig verteilt ist. Auch wenn die reflektierende Fläche mit einer hochreflektierenden Beschichtung versehen ist, kann bei hohen Inzidenzwinkeln oft nur eine unzureichende Reflektivität erzielt werden. Zudem können sich die Reflexionseigenschaften von Reflexionsbeschichtungen bei langanhaltender Bestrahlung mit harter UV-Strahlung im Laufe der Zeit verschlechtern (Schichtdegradation), wodurch die nutzbare Lebensdauer begrenzt wird.

Zusätzlich wird die Strahlung bei der Reflexion an einer solchen Fläche in der Regel polarisationsabhängig dadurch beeinflusst, dass zwischen einer ersten Komponente des elektrischen Feldstärkevektors, die senkrecht zur Einfallsebene schwingt (s-polarisiertes Licht) und einer zweiten Komponente, die parallel zur Einfallsebene schwingt (p-polarisiertes Licht), ein Intensitätsunterschied auftritt (s-p-Aufspaltung).

Der Erfindung liegt die Aufgabe zugrunde, ein Projektionsobjektiv mit einer Strahlumlenkeinrichtung bereitzustellen, bei dem eine Strahlumlenkfläche der Strahlumlenkeinrichtung eine hohe Reflektivität für die auftreffende Strahlung auch bei langanhaltender Bestrahlung aufweist.

Zur Lösung dieser Aufgabe stellt die Erfindung ein Projektionsobjektiv mit den Merkmalen von Anspruch 1 bereit. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei einem erfindungsgemäßen Projektionsobjektiv der eingangs genannten Art ist im Lichtweg zwischen der Objektebene und der Bildebene mindestens eine Strahlumlenkeinrichtung mit mindestens einer Totalreflexionsfläche vorgesehen, die derart gegenüber einer Einfallsrichtung der auf die Totalreflexionsfläche einfallenden Strahlung geneigt ist, dass im wesentlichen die gesamte von der Objektebene kommende und auf die Totalreflexionsfläche auftreffende Strahlung an der Totalreflexionsfläche totalreflektiert wird. Die Totalreflexionsfläche dient somit der Faltung des Lichtwegs zwischen der Objektebene und der Bildebene.

Totalreflexion tritt an einer Grenzfläche zwischen einem optisch dichteren Medium mit Brechzahl n₁ und einem optisch dünneren Medium mit Brechzahl n₂ < n₁ auf, wenn ein Lichtstrahl aus dem optisch dichteren Medium mit einem Inzidenzwinkel größer als arcsin(n₂/n₁) bezüglich der Flächennormalen der Grenzfläche auf diese auftrifft. In diesem Fall tritt kein gebrochener Lichtstrahl in das optisch dünnere Medium ein, vielmehr wird die gesamte Intensität des Lichts an dieser auch als Totalreflexionsfläche bezeichneten Grenzfläche reflektiert.

Die Reflektivität einer solchen Totalreflexionsfläche beträgt somit im Idealfall 100 %. Im Sinne dieser Anmeldung können aber auch Totalreflexionsflächen mit geringeren Reflektivitäten von beispielsweise 90%, 80% oder 70% nützlich sein, wie sie bei Medien mit intrinsischer Absorption auftreten können. Um eine ausreichend hohe Reflektivität zu erreichen, muss die Totalreflexionsfläche so in Bezug auf die gesamte auftreffende Strahlung ausgerichtet sein, dass im wesentlichen alle innerhalb des Strahlbündels auftreffenden Strahlen Inzidenzwinkel haben, die oberhalb des Grenzwinkels der Totalreflexion der Totalreflexionsfläche, aber unterhalb von 90° liegen. Die Strahlumlenkung an der Totalreflexionsfläche kommt ohne das Aufbringen von reflektierenden Schichten auf dieselbe zustande, so dass an dieser Fläche keine die Reflektivität beeinträchtigenden Verschleißerscheinungen durch Schichtdegradation auftreten können. Auch tritt an der Totalreflexionsfläche bei Medien ohne intrinsische Absorption keine Aufspaltung der Intensitäten von s- und p-polarisierter Strahlung auf, wie dies bei Verwendung von häufig in der Nähe des Brewster-Winkels betriebenen Reflexionsschichten zur Strahlumlenkung der Fall ist. Bei geringer intrinsischer Absorption (Absorptionskoeffizient k< 0,001) kann jedoch eine geringe s-p-Intensitätsaufspaltung an der Totalreflexionsfläche auftreten. An der Totalreflexionsfläche kann bei Medien mit oder ohne intrinsische Absorption zusätzlich eine s-p-Phasenaufspaltung, d.h. ein Phasenversatz der orthogonalen Polarisationsrichtungen auftreten.

In weiterer Ausgestaltung der Erfindung ist die Totalreflexionsfläche derart bezüglich der Randstrahlen eines auf die Totalreflexionsfläche einfallenden Strahlungsbündels ausgerichtet, dass die Winkel, welche die Randstrahlen an ihren Reflexionspunkten mit einer Flächennormalen der Totalreflexionsfläche bilden, oberhalb des Grenzwinkels der Totalreflexion des Materials in der Umgebung der Totalreflexionsfläche liegen. Dadurch kann erreicht werden, dass das vollständige Bündel inklusive Randstrahlen an der Totalreflexionsfläche mit im wesentlichen gleichem Reflexionsgrad reflektiert wird, was insbesondere zur Erzeugung von feinsten Auflösungen erforderlich ist. Trifft der Schwerstrahl eines konvergenten oder divergenten Strahlungsbündels schräg auf die Totalreflexionsfläche und ist obige Bedingung für den Teil der Randstrahlen des Strahlungsbündels erfüllt, welche den kleinsten Winkel mit der Flächennormalen der Totalreflexionsfläche bilden, so ist die Bedingung in der Regel auch für alle anderen Strahlen des Bündels erfüllt. Bei einem parallel auftreffenden Strahlungsbündel ist obige Bedingung für alle Strahlen des Bündels gleichermaßen zu erfüllen.

Bei einer Weiterbildung der Erfindung umfasst die Strahlumlenkeinrichtung mindestens ein Prisma mit einer Strahleintrittsfläche, einer Strahlaustrittsfläche und mindestens einer Totalreflexionsfläche, wobei die Strahleintrittsfläche im wesentlichen senkrecht zu einer Strahleinfallsrichtung und/oder die Strahlaustrittsfläche im wesentlichen senkrecht zu einer Strahlaustrittsrichtung ausgerichtet ist. Ein Prisma im Sinne dieser Anmeldung ist ein Körper aus für die verwendete Strahlung transparentem Material, der mindestens zwei Ebenen als Grenzflächen aufweist. Die Strahleintrittsfläche und/oder die Strahlaustrittsfläche sind vorzugsweise eben. Sie können jedoch, z.B. zu Korrektur- oder Kompensationszwecken, auch leicht sphärisch oder asphärisch gekrümmt sein. Durch den senkrechten Eintritt und/oder Austritt der Strahlung wird gewährleistet, dass die Strahlung an der Eintrittsfläche und/oder der Austrittsfläche je nach Strahldivergenz nicht oder nur geringfügig gebrochen wird, wodurch eine zusätzliche Strahlumlenkung an diesen Flächen vermieden wird.

Bei einer Weiterbildung der Erfindung besteht die Strahlumlenkeinrichtung mindestens in der Umgebung der Totalreflexionsfläche aus CaF₂. Der Grenzwinkel der Totalreflexion von CaF₂ mit Luft liegt bei einer Wellenlänge von 157nm, die für die Beleuchtungsstrahlung von katadioptrischen Projektionsobjektive der Mikrolithographie typisch ist, bei ca. 39.8°. Die Totalreflexionsfläche kann daher für Winkel oberhalb dieses Grenzwinkels in einem Projektionsobjektiv betrieben werden, wenn die optischen Komponenten des Objektivs von Gas umgeben sind.

Bei einer Weiterbildung der Erfindung besteht die Strahlumlenkeinrichtung mindestens in der Umgebung der Totalreflexionsfläche aus MgF₂. Der Grenzwinkel der Totalreflexion von MgF₂ mit Luft liegt bei einer Wellenlänge von 157 nm bei ca. 42.5°. Bei der Verwendung von MgF₂ in der Strahlumlenkeinrichtung ist auf die Doppelbrechung dieses Materials zu achten.

In weiterer Ausgestaltung der Erfindung ist das Projektionsobjektiv ein katadioptrisches Projektionsobjektiv, bei dem zwischen der Bildebene und der Objektebene mindestens ein katadioptrischer Objektivteil mit mindestens einer Strahlumlenkeinrichtung und einem Konkavspiegel vorgesehen ist und die Strahlumlenkeinrichtung mindestens eine Totalreflexionsfläche aufweist. Eine Strahlumlenkeinrichtung und ein Konkavspiegel sind als Bestandteile katadioptrischer Objektivteile der hier betrachteten Projektionsobjektive zwingend. Viele katadioptrische Objektive weisen zusätzlich mindestens eine weitere Strahlumlenkeinrichtung auf, so dass eine Vielzahl von Faltungsgeometrien realisiert werden kann. Die Strahlumlenkeinrichtungen solcher katadioptrischer Objektive können jeweils mit einer Totalreflexionsfläche ausgestattet sein.

In einer Weiterbildung der Erfindung ist im Strahlweg vor dem Konkavspiegel eine Strahlumlenkeinrichtung positioniert und diese Strahlumlenkeinrichtung weist mindestens eine Totalreflexionsfläche auf. Hierdurch wird gewährleistet, dass im wesentlichen die gesamte von der Objektebene des Projektionsobjektivs zur Strahlumlenkeinrichtung kommende Strahlung auf den Konkavspiegel trifft. Vorzugsweise ist im Lichtweg hinter dem Konkavspiegel eine zweite Strahlumlenkeinrichtung mit einer Strahlumlenkfläche angebracht, welche unter geringeren Inzidenzwinkeln betrieben wird. Diese kann in der Regel eine ausreichende Reflexion erzeugen, falls sie mit einer hochreflektierenden Reflexbeschichtung versehen ist.

In weiterer Ausgestaltung der Erfindung ist im Strahlweg hinter dem Konkavspiegel eine Strahlumlenkeinrichtung mit mindestens einer Totalreflexionsfläche positioniert. Die Strahlumlenkeinrichtung sollte hierzu in einem ausreichend hohen Inzidenzwinkelbereich betrieben werden.

In einer Weiterbildung der Erfindung ist im Strahlweg vor dem Konkavspiegel eine erste Strahlumlenkeinrichtung und im Strahlweg hinter dem Konkavspiegel eine zweite Strahlumlenkeinrichtung positioniert, wobei die erste und die zweite Strahlumlenkeinrichtung jeweils mindestens eine Totalreflexionsfläche aufweisen. Solche Ausführungsformen zeichnen sich durch besonders niedrige Reflexionsverluste und entsprechend hohe Gesamttransmission aus.

Bei allen Ausführungsformen mit mindestens zwei Strahlumlenkeinrichtungen können die beiden Strahlumlenkeinrichtungen so positioniert sein, dass die Objektebene und die Bildebene des Projektionsobjektivs parallel ausgerichtet sind. Bei zwei Strahlumlenkeinrichtungen ist das durch senkrechte Ausrichtung der reflektierenden Flächen zueinander erreichbar.

In einer Weiterbildung der Erfindung ist die Totalreflexionsfläche der Strahlumlenkeinrichtung gegenüber den Randstrahlen eines im Betrieb des Projektionsobjektivs auf die Totalreflexionsfläche auftreffenden Strahlungsbündels derart geneigt, dass alle Randstrahlen der im Betrieb des Projektionsobjektivs auf die Totalreflexionsfläche der Strahlumlenkeinrichtung auftreffenden Strahlung in einem Winkel von mehr als ca. 39° bezüglich der Flächennormalen auf die Totalreflexionsfläche einfallen. Die Umgebung der Totalreflexionsfläche kann daher beispielsweise aus CaF₂ bestehen, das einen Grenzwinkel der Totalreflexion von ca. 39.8° aufweist. Die numerische Apertur bzw. der halbe Öffnungswinkel des auf die Totalreflexionsfläche auftreffenden Strahlungsbündels muss hierbei derart durch geeignete optische Elemente im Projektionsobjektiv eingestellt werden, dass nicht nur der Schwerstrahl des Bündels, sondern auch die kritischen Randstrahlen oberhalb des Grenzwinkels der Totalreflexion auf die Totalreflexionsfläche auftreffen.

In weiterer Ausgestaltung der Erfindung ist im Strahlweg zwischen einer Totalreflexionsfläche einer ersten Strahlumlenkeinrichtung und einer Totalreflexionsfläche einer zweiten Strahlumlenkeinrichtung eine Polarisationsteilerfläche angebracht, die zur Transmission der von der Totalreflexionsfläche der ersten Strahlumlenkeinrichtung reflektierten Strahlung und zur Reflexion des vom Konkavspiegel reflektierten Strahlung ausgebildet ist. Ein katatdioptrisches Objektiv mit einem solchen Aufbau lässt eine parallele Ausrichtung von Objektebene und Bildebene zu. Mit einem derartigen Aufbau kann außerdem der Konkavspiegel ohne die Verwendung von zusätzlichen optischen Komponenten relativ weit entfernt von der Objektebene des Projektionsobjektivs angeordnet werden, was ein bautechnischer Vorteil ist.

In einer Weiterbildung der Erfindung ist ein objektseitiger Teil der optischen Achse und ein bildseitiger Teil der optischen Achse definiert, wobei der bildseitige Teil der optischen Achse und der objektseitige Teil der optischen Achse koaxial sind. Ein objektseitiger Teil der optischen Achse ist zwischen der Objektebene und einer ersten Faltung des Strahlengangs definiert. Entsprechend ist ein bildseitiger Teil der optischen Achse zwischen einer letzten Faltung des Strahlengangs und der Bildebene definiert. Bei einem Projektionsobjektiv für die Mikrolithographie mit einem gemeinsamen bildseitigen und objektseitigen Teil der optischen Achse tritt wie bei einem rein refraktiven Projektionsobjektiv kein Strahlversatz (OIS, object image shift) auf. Daher kann diese Ausführungsform eines katadioptrischen Projektionsobjektivs anstelle eines refraktiven Projektionsobjektivs in einer Mikrolithographie-Projektionsbelichtungsanlage positioniert werden, ohne dass eine Umkonfiguration des Retikelhalters oder der Waferstage notwendig ist.

In einer Weiterbildung der Erfindung ist das Projektionsobjektiv ein katadioptrisches Projektionsobjektiv, wobei zwischen der Bildebene und der Objektebene mindestens ein katadioptrischer Objektivteil mit mindestens einer Strahlumlenkeinrichtung und einem Konkavspiegel vorgesehen ist, wobei eine durch den Konkavspiegel definierte optische Achse des katadioptrischen Objektivteils und eine objektseitige optische Achse einen Winkel von mehr als 105° einschließen. Der Winkel kann z.B. mindestens 110° oder 120° oder 130° betragen. Durch den hohen Strahlumlenkwinkel wird eine Strahlumlenkung nahe an der Objektebene möglich, da der Konkavspiegel in ausreichender Entfernung von der Objektebene positionierbar ist. Dadurch kann darüber hinaus die Strahlumlenkeinrichtung klein gehalten werden, so dass Material eingespart werden kann.

Die vorstehenden und weitere Merkmale gehen außer aus den Ansprüchen auch aus der Beschreibung und den Zeichnungen hervor. Dabei können die einzelnen Merkmale jeweils für sich alleine oder zu mehreren in Form von Unterkombinationen bei einer Ausführungsform der Erfindung und auf anderen Gebieten verwirklicht sein und vorteilhafte sowie für sich schutzfähige Ausführungen darstellen.
- Fig. 1: ist eine schematische Darstellung einer als Wafer-Scanner ausgebildeten Mikrolithographie-Projektionsbelichtungsanlage, die ein katadioptrisches Projektionsobjektiv mit geometrischer Strahlteilung gemäß einer Ausführungsform der Erfindung umfasst;
- Fig. 2: ist eine schematische Detailansicht des katadioptrischen Objektivteils von Fig. 1 mit einer Strahlumlenkeinrichtung gemäß einer Ausführungsform der Erfindung;
- Fig. 3: ist eine schematische Detailansicht der Strahlumlenkeinrichtung von Fig. 2 mit einem divergenten Strahlenbündel;
- Fig. 4: ist eine schematische Darstellung eines katadioptrischen Projektionsobjektivs mit geometrischer Strahlteilung gemäß einer weiteren Ausführungsform der Erfindung;
- Fig. 5: ist eine schematische Darstellung eines katadioptrischen Projektionsobjektivs mit physikalischer Strahlteilung gemäß einer weiteren Ausführungsform der Erfindung.

Bei der folgenden Beschreibung bevorzugter Ausführungsformen bezeichnet der Begriff "optische Achse" eine gerade Linie oder eine Folge von geraden Linienabschnitten durch die Krümmungsmittelpunkte der optischen Komponenten. Die optische Achse wird an Umlenkspiegeln oder anderen reflektierenden Flächen gefaltet.

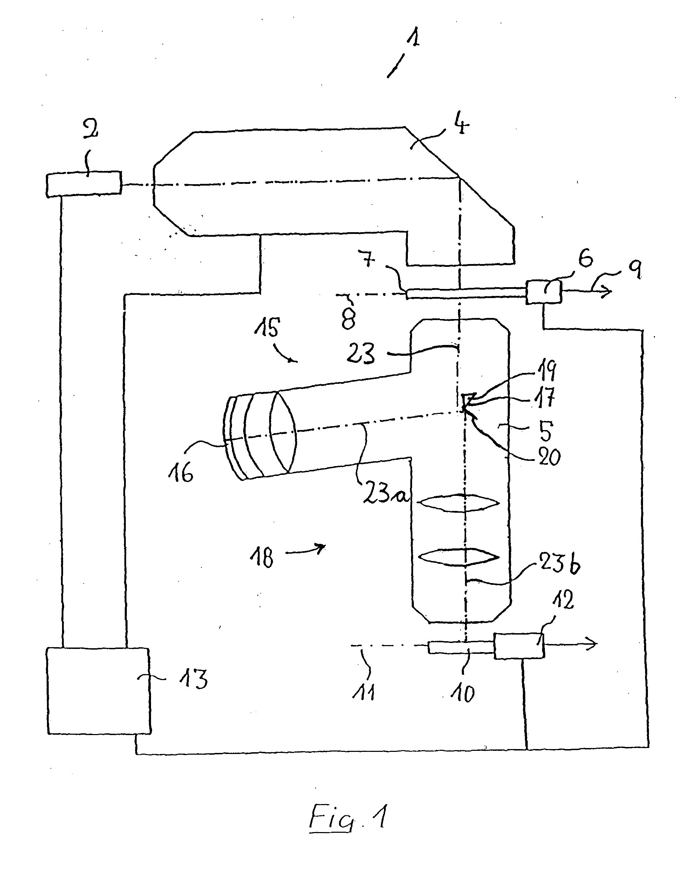

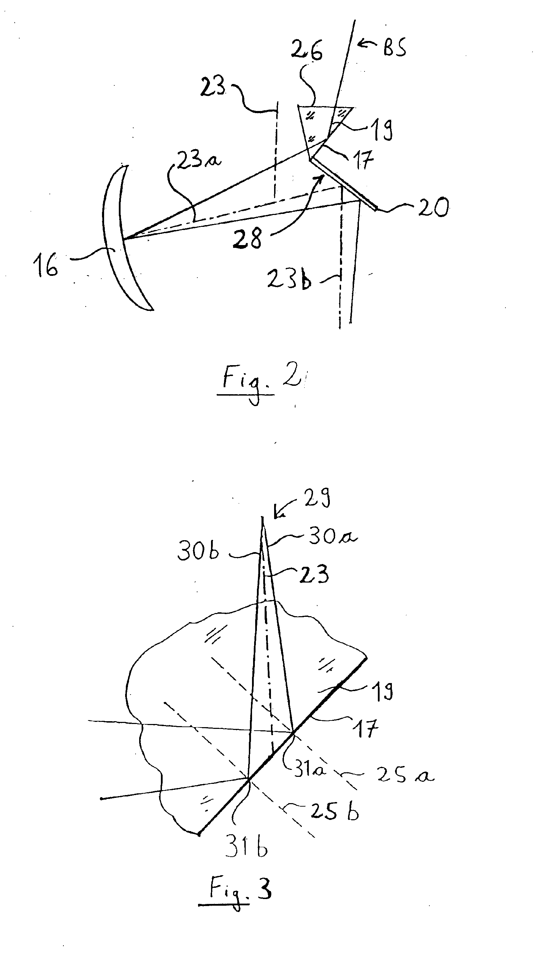

In Fig. 1 ist schematisch eine Mikrolithographie-Projektionsbelichtungsanlage in Form eines Wafer-Scanners 1 gezeigt, der zur Herstellung von hochintegrierten Halbleiterbauelementen vorgesehen ist. Die Projektionsbelichtungsanlage umfasst als Lichtquelle einen Laser 2, der Ultraviolettlicht mit einer Arbeitswellenlänge von 157nm ausstrahlt, die bei anderen Ausführungsformen auch darüber, beispielsweise bei 193nm oder 248nm, oder darunter liegen kann. Ein nachgeschaltetes Beleuchtungssystem 4 erzeugt ein großes, scharf begrenztes und homogen beleuchtetes Bildfeld, das an die Telezentrie-Erfordernisse des nachgeschalteten Projektionsobjektivs 5 angepasst ist. Das Beleuchtungssystem hat Einrichtungen zur Auswahl des Beleuchtungsmodus und ist beispielsweise zwischen konventioneller Beleuchtung mit variablem Kohärenzgrad, Ringfeldbeleuchtung und Dipol- oder Quadrupolbeleuchtung umschaltbar. Hinter dem Beleuchtungssystem ist eine Einrichtung 6 zum Halten und Manipulieren einer Maske 7 so angeordnet, dass die Maske in der Objektebene 8 des Projektionsobjektivs liegt und in dieser Ebene zum Scannerbetrieb in einer Abfahrrichtung 9 (y-Richtung) mittels eines Scanantriebs bewegbar ist.

Hinter der Maskenebene 8 folgt das Projektionsobjektiv 5, das als Reduktionsobjektiv wirkt und ein Bild eines an der Maske angeordneten Musters unter Erzeugung eines reellen Zwischenbildes in reduziertem Maßstab, beispielsweise im Maßstab 1: 4 oder 1: 5, auf einen mit einer Photoresistschicht bzw. Photolackschicht belegten Wafer 10 abbildet, der in der Bildebene 11 des Reduktionsobjektivs angeordnet ist. Andere Reduktionsmaßstäbe, beispielsweise stärkere Verkleinerungen bis 1 : 20 oder 1 : 200 sind möglich. Der Wafer 10 wird durch eine Einrichtung 12 gehalten, die einen Scannerantrieb umfasst, um den Wafer synchron mit dem Retikel 7 parallel zu diesem zu bewegen. Alle Systeme werden von einer Steuereinheit 13 gesteuert.

Das katadioptrische Projektionsobjektiv 5 arbeitet mit geometrischer Strahlteilung und hat zwischen seiner Objektebene (Maskenebene 8) und seiner Bildebene (Waferebene 11) einen katadioptrischen Objektivteil 15 mit einer ersten Strahlumlenkeinrichtung 19 in Form eines Prismas 19. Das Prisma 19 hat eine ebene Totalreflexionsfläche 17, welche derart gegenüber einem objektseitigen Teil der optischen Achse 23 des Projektionsobjektivs 5 gekippt ist, dass die von der Objektebene kommende Strahlung an der Totalreflexionsfläche 17 in Richtung Konkavspiegel 16, der einen Zwischenteil 23a der optischen Achse definiert, praktisch vollständig umgelenkt wird.

Zusätzlich zu dieser für die Funktion des Projektionsobjektivs notwendigen Strahlumlenkeinrichtung 19 ist im Lichtweg hinter dem Konkavspiegel 16 ein ebener Umlenkspiegel 20 als zweite Strahlumlenkeinrichtung vorgesehen, der derart gegenüber der optischen Achse gekippt ist, dass die vom Konkavspiegel 16 reflektierte Strahlung durch den Umlenkspiegel 20 in Richtung Bildebene 11 zu den Linsen des nachfolgenden, dioptrischen Objektivteils 18 umgelenkt wird. Die Totalreflexionsfläche 17 und die Spiegelfläche 20 stehen senkrecht zueinander und haben parallele Kippachsen senkrecht zur optischen Achse 23.

Fig. 2 ist eine schematische Detailansicht des katadioptrischen Objektivteils von Fig. 1 mit der Strahlumlenkeinrichtung 19. Die als Prisma ausgebildete erste Strahlumlenkeinrichtung 19 weist eine gleichschenklige Dreiecksfläche als Grundfläche auf und besteht aus CaF₂. Eine entlang des objektseitigen Teils der optischen Achse 23 einfallende Beleuchtungsstrahlung BS tritt im wesentlichen senkrecht zu einer ersten, als Lichteintrittsfläche 26 dienenden und senkrecht zum objektseitigen Teil der optischen Achse 23 angeordneten, ebenen Fläche in das Prisma 19 ein, wird an der Totalreflexionsfläche 17 des Prismas 19 reflektiert und verlässt das Prisma 19 nahezu senkrecht zu einer zweiten, senkrecht zum Zwischenteil 23a der optischen Achse angeordneten und als Lichtaustrittsfläche 27 dienenden, ebenen Fläche in Richtung auf den Konkavspiegel 16. Der objektseitige Teil der optischen Achse 23 des Projektionsobjektivs ist um ca. 52.5° gegenüber der Flächennormale der Totalreflexionsfläche 17 geneigt, so dass parallel zur optischen Achse 23 auf die Totalreflexionsfläche auftreffende Beleuchtungsstrahlung eine Umlenkung um 105° in Richtung auf den Konkavspiegel 16 erfährt. Der im wesentlichen senkrechte Durchtritt der Strahlung durch die Lichteintrittsfläche 26 und die Lichtaustrittsfläche 27 verhindert weitestgehend eine Brechung der Strahlung an diesen Flächen.

Die Totalreflexionsfläche 17 reflektiert die einfallende Strahlung oberhalb des Grenzwinkels der Totalreflexion, der sich für die Grenzfläche 17 zwischen CaF₂ (Brechzahl n₁= 1,558 bei einer Wellenlänge von ca. 157 nm bzw. von n₁= 1,501 bei ca. 193 nm) und Luft (Brechzahl n₂=1,0) zu arcsin(n₂/n₁)=39,9° bzw. zu 41, 8° ergibt. Alternativ kann das Prisma 19 z.B. auch aus MgF₂ hergestellt werden. Bei einer Wellenlänge von ca. 157 nm beträgt die Brechzahl von MgF₂ n₁= 1,466, so dass der Grenzwinkel der Totalreflexion an der Grenzfläche 17 einen Wert von 43,0° hat.

Bei einer Wellenlänge von ca. 193 nm ist auch die Verwendung von SiO₂ als Prismenmaterial möglich. Hierbei muss zwischen einkristallinem, doppelbrechendem Silizium und synthetisch hergestelltem, keine Doppelbrechung aufweisenden Silizium (synthetischem Quarzglas) unterschieden werden. Ersteres hat bei einer Wellenlänge von 193 nm eine Brechzahl von n₁= 1,66 (ordentlicher Strahl) und somit einen Totalreflexionswinkel von 37,0°, letzteres eine Brechzahl von n₁= 1,56 und einen Totalreflexionswinkel von 39,9°. Die Auswahl des Prismenmaterials erlaubt somit eine Steuerung des Totalreflexionswinkels.

Das Projektionsobjektiv 5 ist auf eine solche Weise ausgestaltet, dass die Totalreflexionsfläche 17 innerhalb eines Inzidenzwinkelbereichs von 40° bis 65° von Belichtungsstrahlung getroffen wird, so dass die Bedingung der Überschreitung des Grenzwinkels der Totalreflexion für alle Strahlen des einfallenden Bündels erfüllt ist. Der Schwerstrahlwinkel des Bündels liegt bei 52.5° und der halbe Öffnungswinkel des einfallenden Strahlbündels bei maximal 12.5°.

Von der Lichtaustrittsfläche 27 fällt die Beleuchtungsstrahlung auf den Konkavspiegel 16, wird von diesem reflektiert und trifft auf eine Spiegelfläche 28 des Umlenkspiegels 20, an der diese in Richtung auf die Bildebene 11 entlang eines bildseitigen Teils 23b der optischen Achse des Projektionsobjektivs umgelenkt wird. Die Spiegelfläche 28 des Umlenkspiegels 20 wird in einem Inzidenzwinkelbereich von ca. 29° bis ca. 49° betrieben. Die Inzidenzwinkel an dem als zweite Strahlumlenkeinrichtung dienenden Umlenkspiegel 20 sind so gering, dass diese mit einer im gesamten Inzidenzwinkelbereich hochreflektierenden Reflexionsbeschichtung belegt sein kann.

Auf der Spiegelfläche 28 ist eine hochreflektierende Beschichtung in Form eines dielektrisch verstärkten Metallspiegels aufgebracht. Die Konkavspiegelfläche ist hingegen rein dielektrisch ausgestaltet, da diese nicht unter einem hohen Inzidenzwinkelbereich betrieben wird. Die Lichteintrittsfläche 26 und der Lichtaustrittsfläche 27 des Prismas 19 weisen hingegen Antireflexbeschichtungen auf.

Fig. 3 zeigt eine schematische Detailansicht der Strahlumlenkeinrichtung 19 von Fig. 2 mit einem divergenten Strahlbündel 29, dessen halber Öffnungswinkel bei ca. 12.5° liegt, in Fig.3 aber ungefähr halb so groß gezeichnet ist, um die Darstellung zu vereinfachen. Der Schwerstrahl des Strahlbündels 29 verläuft vor der Strahlumlenkung an der Totalreflexionsfläche 17 entlang der optischen Achse 23 des Projektionsobjektivs 5. Die zwei Randstrahlen 30a, 30b des Strahlbündels 29 treffen an einem ersten und einem zweiten Reflexionspunkt 31 a, 31 b auf die Totalreflexionsfläche 17, und zwar bezüglich der Flächennormalen 31a, 31b unter einem Winkel von ca. 65° für den ersten Randstrahl 30a und unter einem Winkel von ca. 40° für den zweiten Randstrahl 30b. Der kritische erste Randstrahl 30a trifft somit unter einem Winkel bezüglich zur Flächennormalen 31 a auf die Totalreflexionsfläche 17, der größer ist als der Grenzwinkel der Totalreflexion von 39,8°. Die gesamte Strahlung inklusive der beiden Randstrahlen 30a, 30b wird daher an der Totalreflexionsfläche 17 totalreflektiert und verläuft divergent weiter in Richtung des Konkavspiegels 16. Das einfallende Strahlbündel 29 erfüllt somit die Bedingung, dass im wesentlichen die gesamte auf die Totalreflexionsfläche einfallende Strahlung an dieser totalreflektiert wird. Bei einem konvergenten Strahlverlauf wäre der zweite Randstrahl der für die Erfüllung der Totalreflexionsbedingung kritische Strahl.

Es kann sich für die Totalreflexion als günstig erweisen, wenn das von der Objektebene 8 kommende Strahlungsbündel eine geringe numerische Apertur aufweist. Es kann daher angezeigt sein, optische Elemente mit positiver Brechkraft zwischen der Objektebene 8 und der ersten Strahlumlenkeinrichtung 19 zu positionieren.

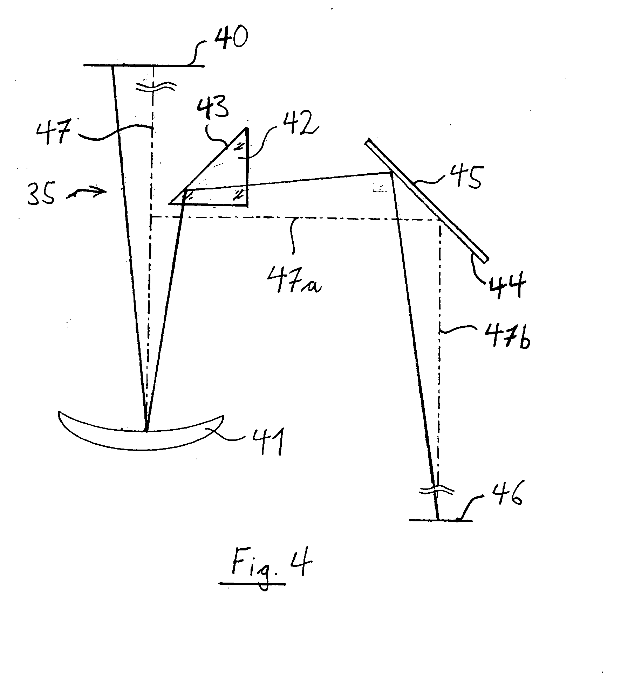

Fig. 4 zeigt beispielhaft eine schematische Darstellung einer, auch als h-Geometrie bezeichneten, Faltungsgeometrie eines katadioptrischen Projektionsobjektivs mit geometrischer Strahlteilung, welche sich durch die Verwendung einer erfindungsgemäßen Strahlumlenkeinrichtung mit großer Reflektivität bei hohem Inzidenzwinkel auszeichnet. Das Projektionsobjektiv 35 hat, der Richtung des Strahlweges folgend, eine Objektebene 40, die einen objektseitigen Teil 47 der optischen Achse definiert, einen Konkavspiegel 41 und dahinter eine erste Strahlumlenkeinrichtung 42. Diese ist als Prisma mit einer rechtwinkligen, gleichschenkligen Dreiecksfläche als Grundfläche ausgebildet. Sie weist eine Hypotenusenfläche 43 auf, die als erste Totalreflexionsfläche dient. Eine zweite Strahlumlenkeinrichtung 44 ist im Lichtweg hinter der ersten Strahlumlenkeinrichtung 42 angeordnet und weist eine Spiegelfläche auf, welche die Strahlung auf eine im Lichtweg nachfolgende Objektebene 46 umlenkt. Der schematisch gezeigte Hauptstrahl der Abbildung verläuft von der Objektebene 40 über den Konkavspiegel 41 zur ersten Totalreflexionsfläche 43, wird an dieser um ca. 100° umgelenkt und trifft auf die Reflexionsfläche 45, von der er ebenfalls um ca. 100° umgelenkt wird und in Richtung der Bildebene 46 weiterläuft. Die als Strahleintrittsfläche und Strahlaustrittsfläche dienenden Kathetenflächen des Prismas 42 werden von der hindurchtretenden Strahlung nahezu senkrecht getroffen, so dass eine Strahlbrechung an diesen Flächen weitgehend vermieden werden kann. Durch den in Fig. 4 gezeigten Aufbau wird eine parallele Ausrichtung von Objektebene 40 und Bildebene 46 des Projektionsobjektivs 35 ermöglicht.

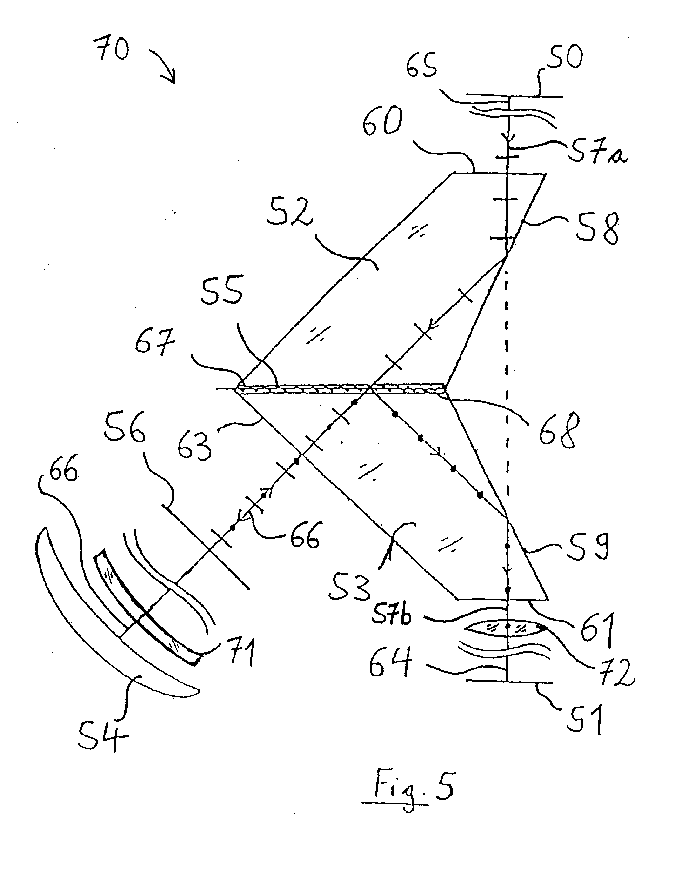

Fig. 5 ist eine schematische Darstellung eines katadioptrischen Projektionsobjektivs mit physikalischer Strahlteilung gemäß einer weiteren Ausführungsform der Erfindung. Das Projektionsobjektiv 70 weist dem Strahlverlauf folgend eine Objektebene 50 und eine erste Strahlumlenkeinrichtung 52 mit einer ersten Totalreflexionsfläche 58 auf. Die Strahlumlenkeinrichtung 52 ist als ein Prisma mit viereckiger Grundfläche ausgebildet und besteht aus CaF₂. Eine erste und eine zweite ebene Seitenfläche 60, 67 des Prismas 52 liegen zueinander parallel einander gegenüber und sind parallel zur Objektebene 50 und einer Bildebene 51 des Projektionsobjektivs 70 ausgerichtet. Die Totalreflexionsfläche 58 bildet eine Seitenfläche des Prismas 52, welche einen objektseitigen Teil 57a der optische Achse des Projektionsobjektivs 70 schneidet und gegenüber dieser um ca. 67,5° (zur Flächennormale) geneigt ist.

Im Lichtweg hinter der Strahlumlenkeinrichtung 52 sind entlang einer optischen Achse 66 des katadioptrischen Objektivteils eine λ/4 Platte 56 und mindestens eine Negativlinse 71 vor einem Konkavspiegel 54 positioniert. Eine zweite Strahlumlenkeinrichtung 53 mit einer zweiten Totalreflexionsfläche 59 ist im Lichtweg dahinter positioniert. Die zweite Strahlumlenkeinrichtung 53 weist eine zur ersten Strahlumlenkeinrichtung 52 identische, prismatische Bauform auf und besteht ebenfalls aus CaF₂. Sie weist ebenfalls eine erste und eine zweite Seitenfläche 68, 61 auf, welche parallel zueinander einander gegenüber liegen und parallel zur Objektebene 50 und Bildebene 51 des Projektionsobjektivs 70 ausgerichtet sind. Die Totalreflexionsfläche 59 bildet eine Seitenfläche des Prismas 53, welche einen bildseitigen Teil der optischen Achse 57b des Projektionsobjektivs 70 schneidet bzw. faltet. Eine Anzahl von Linsen, symbolisiert durch eine Positivlinse 72, ist im Lichtweg zwischen der zweiten Strahlumlenkeinrichtung 53 und der Bildebene 51 positioniert.

Die zweite Seitenfläche 67 der ersten Strahlumlenkeinrichtung 52 und die erste Seitenfläche 68 der zweiten Strahlumlenkeinrichtung 53 stoßen an einer Polarisationsteilerfläche 55 aneinander. Die beiden Prismen 52, 53 sind spiegelsymmetrisch zur Polarisationsteilerfläche 55 angeordnet.

Die Polarisationsteilerfläche 55 ist so ausgelegt, dass bei der Transmission von Strahlung vom ersten Prisma 52 in das zweite Prisma 53 im wesentlichen kein Lichtverlust auftreten kann. Die Polarisationsteilerfläche 55 wird durch ein dielektrisches Schichtsystem gebildet, bei dem sich mehrere Einzelschichten mit hohem und niedrigem Brechungsindex abwechseln.

Die Objektebene 50 und die Bildebene 51 sind parallel angeordnet. Eine objektseitige optische Achse 65 und eine bildseitige optische Achse 64 des Projektionsobjektivs sind koaxial. Daher tritt bei dieser Ausführungsform des Projektionsobjektivs wie bei einem gewöhnlichen, rein refraktiven Projektionsobjektiv kein Strahlversatz (OIS, object image shift) auf.

Im Betrieb des Projektionsobjektivs 70 wird linear polarisierte Strahlung von der Objektebene 50 aus in das Projektionsobjektiv 70 entlang der optischen Achse 57 eingestrahlt. Die Polarisationsrichtung dieser Strahlung steht parallel zur Einfallsebene auf die erste Totalreflexionsfläche 58 (p-Polarisation). Sie trifft senkrecht auf eine Eintrittsfläche 60 des ersten Prismas 52, so dass eine Brechung an dieser Fläche weitgehend vermieden wird. Im Inneren des Prismas trifft die Strahlung auf die Totalreflexionsfläche 58, an der sie unter einem hohen Winkel von ca. 135° in Richtung der optischen Achse 66 des katadioptrischen Objektivteils umgelenkt wird. Die Strahlung läuft weiter entlang der optischen Achse 66, wobei sie die Strahlteilerfläche 55 in Transmission durchläuft und senkrecht zu einer Seitenfläche 63 des zweiten Prismas 53 dieses verlässt. Die Strahlung tritt durch die λ/4 Platte 56 und läuft von dort aus weiter zum Konkavspiegel 54, an dem sie reflektiert wird, so dass die λ/4 Platte 56 ein zweites Mal von ihr durchlaufen wird. Der zweimalige Durchtritt durch die λ/4 Platte 56 bewirkt eine Phasenverschiebung von λ/2 des elektrischen Feldstärkevektors, so dass dieser um 90° gedreht wird und nun senkrecht zur Einfallsebene auf die Polarisationsteilerfläche 55 steht (s-Polarisation). Nach erneutem senkrechten Durchtritt durch die Seitenfläche 63 des zweiten Prismas 53 trifft die Strahlung auf die Polarisationsteilerfläche 55 und wird aufgrund der Tatsache, dass sie nun s-polarisiert ist, an dieser um ca. 90° in Richtung auf die zweite Totalreflexionsfläche 59 umgelenkt. An der Totalreflexionsfläche 59 wird sie ein zweites Mal unter einem Winkel von ca. 135° totalreflektiert, so dass sie entlang der optischen Achse 57 weiterläuft und das zweite Prisma 53 senkrecht zu einer Strahlaustrittsfläche 61 verlässt. Sie läuft danach weiter in Richtung auf die Bildebene 51, wobei sie hinter der Strahlumlenkeinrichtung ein reelles Zwischenbild erzeugt.

Ein Vorteil der in Fig. 5 gezeigten Anordnung liegt in der Tatsache, dass die Strahlung die Prismeneintrittsflächen 60,63 und Prismenaustrittsfläche 63,61 nahezu senkrecht durchstrahlt, so dass keine Brechung an diesen Flächen auftritt. Um dies zu erreichen, soll insbesondere die Seitenfläche 63 des zweiten Prismas 53 im wesentlichen senkrecht zur optischen Achse 66 des katadioptrischen Objektivteils ausgerichtet sein. Optional kann eine nicht bildlich dargestellte Positivlinse in den Strahlengang direkt hinter der Objektebene 50 eingebracht werden, um eine weitgehende Parallelisierung der auf die Strahleintrittsfläche 60 des ersten Prismas 52 einfallenden Strahlung zu erzielen.

Ein weiterer Vorteil der in Fig. 5 gezeigten Ausführungsform ist die Tatsache, dass die erste und die zweite Strahlumlenkeinrichtung 52, 53 identische Bauform aufweisen, so dass mit der Herstellung einer Bauform beide Strahlumlenkeinrichtungen gebildet werden können.

Durch den großen Umlenkwinkel von ca. 135° an der ersten Totalreflexionsfläche 58 wird eine Positionierung des Konkavspiegels 54 weit von der Objektebene 50 bei gleichzeitiger Strahlumlenkung in der Nähe der Objektebene 50 ermöglicht. Außerdem kann durch den großen Neigungswinkel von 67.5° der Flächennormalen der Totalreflexionsfläche 58 bezüglich der optischen Achse 57 auch ein Strahlbündel mit hoher numerischer Apertur mit einem halben Öffnungswinkel von theoretisch bis zu 22.5° vollständig totalreflektiert werden.

Die in Fig. 5 gezeigte Anordnung ist nur ein Beispiel für eine vorteilhafte Ausführungsform eines erfindungsgemäßen Projektionsobjektivs. Es versteht sich, dass die Verwendung von großen Umlenkwinkeln in Strahlumlenkeinrichtungen von Projektionsobjektiven bei gleichzeitiger hoher Reflektivität selbst bei langanhaltender UV-Bestrahlung sich auch in vielen anderen, hier nicht bildlich dargestellten Ausführungsformen vorteilhaft auswirken kann.

## Patentansprüche

1. Projektionsobjektiv (5; 35; 70) für die Mikrolithographie zur Abbildung eines in einer Objektebene (8; 40; 50) des Projektionsobjektivs (5; 35; 70) angeordneten Musters in eine Bildebene (11; 46; 51) des Projektionsobjektivs (5; 35; 70), bei dem im Lichtweg zwischen der Objektebene (8; 40; 50) und der Bildebene (11; 46; 51) mindestens eine Strahlumlenkeinrichtung (19; 42; 44; 52; 53) mit mindestens einer Totalreflexionsfläche (17; 43; 45; 58; 59) vorgesehen ist, die derart gegenüber einer Einfallsrichtung der auf die Totalreflexionsfläche (17; 43; 45; 58; 59) einfallenden Strahlung geneigt ist, dass im wesentlichen die gesamte von der Objektebene (8; 40; 50) kommende und auf die Totalreflexionsfläche (17; 43; 45; 58; 59) auftreffende Strahlung an der Totalreflexionsfläche (17; 43; 45; 58; 59) totalreflektiert wird.

2. Projektionsobjektiv nach Anspruch 1, bei dem die Totalreflexionsfläche (17; 43; 45; 58; 59) derart bezüglich der Randstrahlen (30a, 30b) eines auf die Totalreflexionsfläche (17; 43; 45; 58; 59) einfallenden Strahlungsbündels (29) ausgerichtet ist, dass die Winkel, welche die Randstrahlen (30a, 30b) an ihren Reflexionspunkten (31 a, 31 b) mit einer Flächennormalen (25a, 25b) der Totalreflexionsfläche (17; 43; 45; 58; 59) bilden, oberhalb eines Grenzwinkels der Totalreflexion des Materials der Strahlumlenkeinrichtung (19; 42; 44; 52; 53) liegen.

3. Projektionsobjektiv nach Anspruch 1 oder 2, bei dem die Strahlumlenkeinrichtung (19; 42; 44; 52; 53) mindestens ein Prisma (19; 42; 44; 52; 53) mit einer Strahleintrittsfläche (26; 60; 63), einer Strahlaustrittsfläche (27; 61; 63) und mindestens einer Totalreflexionsfläche (17; 43; 45; 58; 59) umfasst, wobei die Strahleintrittsfläche (26; 60; 63) im wesentlichen senkrecht zu einer Strahleinfallsrichtung und/oder die Strahlaustrittsfläche (27; 61; 63) im wesentlichen senkrecht zu einer Strahlaustrittsrichtung ausgerichtet ist.

4. Projektionsobjektiv nach einem der vorherigen Ansprüche, bei dem die Strahlumlenkeinrichtung (19; 42; 44; 52; 53) mindestens in der Umgebung der Totalreflexionsfläche (17; 43; 45; 58; 59) aus CaF₂ besteht.

5. Projektionsobjektiv nach einem der Ansprüche 1 bis 3, bei dem die Strahlumlenkeinrichtung (19; 42; 44; 52; 53) mindestens in der Umgebung der Totalreflexionsfläche (17; 43; 45; 58; 59) aus MgF₂ besteht.

6. Projektionsobjektiv nach einem der vorhergehenden Ansprüche, bei dem das Projektionsobjektiv (5; 35; 70) ein katadioptrisches Projektionsobjektiv (5; 35; 70) ist, wobei zwischen der Bildebene (11; 46; 51) und der Objektebene (8; 40; 50) mindestens ein katadioptrischer Objektivteil (15) mit mindestens einer Strahlumlenkeinrichtung (19; 42; 44; 52; 53) und einem Konkavspiegel (16; 41; 54) vorgesehen ist und bei der die Strahlumlenkeinrichtung (19; 42; 44; 52; 53) mindestens eine Totalreflexionsfläche (17; 43; 45; 58; 59) aufweist.

7. Projektionsobjektiv nach Anspruch 6, bei dem im Strahlweg vor dem Konkavspiegel (16; 54) eine Strahlumlenkeinrichtung (19; 52) positioniert ist und bei dem die Strahlumlenkeinrichtung (19; 52) mindestens eine Totalreflexionsfläche (17; 58) aufweist.

8. Projektionsobjektiv nach Anspruch 6, bei dem im Strahlweg hinter dem Konkavspiegel (16; 41; 54) eine Strahlumlenkeinrichtung (44; 53) positioniert ist und bei dem die Strahlumlenkeinrichtung (44; 53) mindestens eine Totalreflexionsfläche (45;59) aufweist.

9. Projektionsobjektiv nach Anspruch 6, bei dem im Strahlweg vor dem Konkavspiegel (54) eine erste Strahlumlenkeinrichtung (52) und im Strahlweg hinter dem Konkavspiegel (54) eine zweite Strahlumlenkeinrichtung (53) positioniert ist und bei dem die erste (52) und die zweite (53) Strahlumlenkeinrichtung jeweils mindestens eine Totalreflexionsfläche (58; 59) aufweisen.

10. Projektionsobjektiv nach Anspruch 6, bei dem im Strahlweg hinter dem Konkavspiegel (41) eine erste Strahlumlenkeinrichtung (42) und im Strahlweg hinter der ersten Strahlumlenkeinrichtung (42) eine zweite Strahlumlenkeinrichtung (44) positioniert ist, wobei die erste (42) und die zweite (44) Strahlumlenkeinrichtung jeweils mindestens eine Totalreflexionsfläche (43; 45) aufweisen.

11. Projektionsobjektiv nach einem der Ansprüche 6 bis 10, bei dem die Totalreflexionsfläche (17) der Strahlumlenkeinrichtung (17; 43; 58) gegenüber allen Randstrahlen (30a, 30b) eines im Betrieb des Projektionsobjektivs (5; 35; 70) auf die Totalreflexionsfläche (17) auftreffenden Strahlungsbündels derart geneigt ist, dass die Randstrahlen (30a, 30b) in einem Winkel von mehr als ca. 39° bezüglich der Flächennormalen (25a; 25b) auf die Totalreflexionsfläche (17; 43; 58) einfallen.

12. Projektionsobjektiv nach Anspruch 6, bei dem im Strahlweg zwischen einer Totalreflexionsfläche (58) einer ersten Strahlumlenkeinrichtung (52) und einer Totalreflexionsfläche (59) einer zweiten Strahlumlenkeinrichtung (53) eine Polarisationsteilerfläche (55) angebracht ist, die zur Transmission der von der Totalreflexionsfläche (58) der ersten Strahlumlenkeinrichtung (52) reflektierten Strahlung und zur Reflexion der vom Konkavspiegel (54) rückgestrahlten Strahlung ausgelegt ist.

13. Projektionsobjektiv nach einem der vorhergehenden Ansprüche, bei dem ein objektseitiger Teil der optischen Achse (65) und ein bildseitiger Teil der optischen Achse (64) definiert sind, wobei der bildseitige Teil der optischen Achse (64) und der objektseitige Teil der optischen Achse (65) koaxial sind.

14. Projektionsobjektiv nach einem der vorhergehenden Ansprüche, bei dem das Projektionsobjektiv (5; 35; 70) ein katadioptrisches Projektionsobjektiv (5; 35; 70) ist, wobei zwischen der Bildebene (11; 46; 51) und der Objektebene (8; 40; 50) mindestens ein katadioptrischer Objektivteil (15) mit mindestens einer Strahlumlenkeinrichtung (19; 42; 44; 52; 53) und einem Konkavspiegel (16; 41; 54) vorgesehen ist, wobei eine durch den Konkavspiegel (16; 41; 54) definierte optische Achse (66) des katadioptrischen Objektivteils (15) und eine objektseitige optische Achse (65) einen Winkel von mehr als 105° einschließen.
